# EUROPEAN PATENT APPLICATION

(11) **EP 4 528 577 A1**
(43) Date of publication of application: **26.03.2025**
(21) Application number: 24200854.8
(22) Date of filing: 17.09.2024
(51) Int. Cl.: G06F 40/166, G06F 16/3329, G06F 40/186, G06T 11/60

(54) **SYSTEMS AND METHODS FOR AUTOMATICALLY GENERATING DESIGNS**

(30) Priority: 22.09.2023 AU 2023903062
(71) Applicant: Canva Pty Ltd., Surry Hills, New South Wales 2010 (AU)
(72) Inventor: RADFORD, William Edward John, Surry Hills, NSW 2010 (AU); RUSHTON, Ryan Arthur Robert, Surry Hills, NSW 2010 (AU); JENSEN, Wade Daniel, Surry Hills, NSW 2010 (AU); LACKO, Jarrah James Jack, Surry Hills, NSW 2010 (AU); YILDIRIM, Gökhan, Surry Hills, NSW 2010 (AU); RANA, Aditya Sangram Singh, Surry Hills, NSW 2010 (AU)
(74) Representative: Chettle, John Edward

(57) **Abstract**

Described herein is a computer implemented method for automatically generating a design. The method includes receiving an input prompt for generating the design and generating a design outline based on the input prompt. The design outline includes a style descriptor for the design. The method further includes retrieving a design template based on the design outline. The design template includes a placeholder design element. The method further includes retrieving at least one design element for the placeholder element. The design is generated by populating the placeholder element with the design element.

## Description

### INCORPORATION BY REFERENCE

The entire contents of Australian standard application number 2023210536 for Systems and methods for processing designs, filed on 31 July 2023, are herein incorporated by reference.

### TECHNICAL FIELD

Aspects of the present disclosure are directed to systems and methods for automatically generating designs.

### BACKGROUND

Computer applications for creating and working with designs exist. Some such applications may provide users with the ability to create designs in different formats. Generally speaking, such applications allow users to create a design by, for example, creating a page and adding design elements to that page. Such applications may provide a number of design templates in various design categories to aid users in creating designs.

Whilst computer tools for manually generating such designs exist, the generation of designs is generally a time consuming and at times a complex task requiring the manual generation of text content and retrieval of suitable media content tailored to the design topic or theme.

Accordingly, there exists a need for more intelligent computer applications that can assist users in creating designs

### SUMMARY

Described herein is a computer implemented method for automatically generating designs, the method including: receiving an input prompt for generating the design; generating a design outline based on the input prompt, the design outline including a style descriptor for the design; retrieving a design template based on the design outline, the design template including a placeholder design element; retrieving at least one design element for the placeholder element; and generating the design by populating the placeholder element with the design element.

In some embodiments, generating the design outline includes: generating a design outline prompt, the design outline prompt including the input prompt; and communicating the design outline prompt to a first machine learning system configured to generate the design outline based on the design outline prompt. In some embodiments, the design outline prompt further includes configuration data to configure the first machine learning system to generate the design outline. In some embodiments, retrieving the design element includes: generating a design element prompt, the design element prompt including the input prompt; communicating the design element prompt to a second machine learning system configured to generate the design element based on the input prompt. In some embodiments, the design element prompt further includes configuration data to configure the second machine learning system to generate the design element, wherein the configuration data is based on a type of the placeholder element. In some embodiments, generating the design element includes: processing data associated with the design template to identify the placeholder element. In some embodiments, the placeholder element includes a text hierarchy level and the design element is retrieved based on the text hierarchy level.

In some embodiments, the design outline includes a media query. In some embodiments, retrieving the design template includes searching a template library using the style descriptor and retrieving the design template from search results. In some embodiments, the method further includes searching a style attributes library for a style attribute palette using the style descriptor and selecting the style attribute palette. In some embodiments, generating the design includes applying the style attribute to the design template. In some embodiments, the style attribute includes a colour palette for colouring a shape element of the design; and a font palette for formatting a text element of the design. In some embodiments, the method further includes searching a media item library for a media item using the media query and selecting the media item. In some embodiments, the design template includes a placeholder shape element and the method further includes populating the placeholder shape element with the media item.

Also described herein is a computer processing system including one or more computer processing units; and a non-transitory computer-readable medium storing instructions which, when executed by the one or more computer processing units, cause the one or more computer processing units to perform the computer-implemented method described above.

Also described herein is a non-transitory storage storing instructions executable by one or more computer processing units to cause the one or more computer processing units to perform the method described above.

### BRIEF DESCRIPTION OF THE DRAWINGS

In the drawings:
FIG. 1 is a diagram depicting an example network environment for performing various features of the present disclosure.
FIG. 2 is a block diagram of an example computer processing system.
FIG. 3 is a process flowchart depicting an example method for automatically generating one or more candidate designs in response to an input prompt.
FIG. 4 is a process flowchart depicting an example method for automatically generating design outlines for the one or more candidate designs.
FIG. 5 is a process flowchart depicting an example method for retrieve or selecting design components for the one or more candidate designs based on the design outlines.
FIG. 6 is a process flowchart depicting an example method for generating text content for the one or more candidate designs.
FIG. 7 is a process flowchart depicting an example method for generating and outputting the one or more candidate designs.
FIG. 8 is an example user interface displaying candidate designs according to some aspects of the present disclosure.
Fig. 9 is an example user interface for receiving user input.

While the description is amenable to various modifications and alternative forms, specific embodiments are shown by way of example in the drawings and are described in detail. It should be understood, however, that the drawings and detailed description are not intended to limit the invention to the particular form disclosed. The intention is to cover all modifications, equivalents, and alternatives falling within the scope of the present invention as defined by the appended claims.

### DETAILED DESCRIPTION

In the following description, numerous specific details are set forth in order to provide a thorough understanding of the present invention. It will be apparent, however, that the present invention may be practiced without these specific details. In some instances, well-known structures and devices are shown in block diagram form in order to avoid unnecessary obscuring.

As discussed above, computer applications for use in creating and managing designs exist. Such applications may provide mechanisms for a user to create a design, edit the design by adding content to it, and output the design in various ways (e.g. by saving, displaying, printing, publishing, sharing, or otherwise outputting the design). As also discussed above, an application may provide a user with the ability to create and manage designs of different formats - such as cards, posts, posters, presentations, documents, etc.

As further discussed above, many scenarios arise in which a user may wish to create a design, for example, to present on a topic. At a general level, creating a design involves a user selecting a design template. Generally speaking, a design template includes a plurality of customizable/placeholder elements, such as text boxes, image boxes, shapes, banners, borders, colour themes and the like, which are configured to receive design elements from the user. Design templates may thus provide a structure to position the content of a design for display. Some computer applications may include different types of design templates suitable for different types of designs - for example, it may include design templates for presentations, design templates for posters, design templates for invitation cards, design templates for social media posts, etc. Depending on the type of design the user wishes to create, the user may select a design template from the available templates suitable for that design type and then customize that design template by adding design elements to the design template. The design elements include, for example, text content (e.g. a sequence of one or more characters) and shape content. Shape content may include media content (e.g., images, videos, audio clips) and fill content (e.g., shapes in a solid colour or colour gradient). The user then manually deletes one or more placeholder elements, adds one or more placeholder elements, moves one or more placeholder elements around, and adds design elements to the placeholder elements until the user is satisfied with the resulting design. It will be appreciated that where applications provide a large number of design templates, for example, in excess of a million, the browsing and selection of design templates may be extensive for users. Once the user has selected a template, conventionally, the user is still required to manually generate text content and retrieve media times to populate such a selected template. This can be a cumbersome and time intensive exercise for a user and may often result in poorly created designs - e.g., designs that do not include suitable media content or fill content that matches the text content of the design, or the design template is not particularly suitable for the design.

Aspects of the present disclosure address one or more of these issues with conventional design generation processes by providing systems and methods that automatically and intelligently generate one or more candidate designs based on an input prompt. In particular, the systems and methods are configured to analyse the input prompt and 1) select one or more design templates, 2) select or generate design elements for each of the selected one or more design templates, and 3) generate the one or more candidate designs by transferring the selected or generated design elements to respective design templates.

To select the one or more design templates, the presently disclosed systems and methods determine one or more design categories (e.g., posts, social media post, presentation, invitation card, etc.) and a design style (e.g., vibrant, vintage, classy, etc.) based on the input prompt. The identified design category (or categories) and design style is then utilized to select one or more design templates for the design.

Once the systems and methods select the design templates, the systems and methods identify the placeholder design elements of the design templates and automatically generate or select content for the placeholder design elements based on the input prompt and the identified design style. For example, if a design template includes two text-based placeholder design elements for a heading and a sub-topic and one placeholder design element for an image, the systems and methods automatically generate text for the text-based design elements based on the input prompt and/or the design type and the design style.

Furthermore, the systems and methods may automatically generate one or more media queries for the image placeholder elements based on the input prompt and then perform a search in a media library for media items that match that media query.

Finally, the systems and methods transfer the generated design elements into the placeholder elements of the selected design templates to generate the one or more candidate designs. These candidate designs may then be displayed on a user device of the user that generated the initial input prompt.

In some embodiments of the present disclosure, a generative machine learning (ML) model may be utilized to determine the design style (also referred to as a style descriptor herein) and generate the media queries based on the input prompt. The design style and media query in combination is referred to as a design outline in the present disclosure. Further, the machine learning model may be utilized to generate the text content for the text-based placeholder elements in the selected design templates.

In some embodiments, a first input prompt is generated and provided to the generative ML model, which generates the design outline based on the first input prompt. One or more design templates are selected based on the design outline. A set of second input prompts (e.g., based on the selected design templates) are then generated and provided to the ML model, which generates the text content of the text-based placeholders of the selected design templates based on each of the second prompts in the set of second prompts.

The generative ML model may be trained using configuration data and some-shot examples to accurately generate the design outline and text content.

The media queries generated by the ML model may be utilized to search a media library for media items and select a media item for respective pages. The style descriptor generated by the ML model may be utilized to search a template library for design templates and select a template for generating the design. The style descriptor may also be utilized to search a style attribute library for style attributes and select style attributes for applying to the design elements in the design template.

### Example design data structures

Data in respect of designs that have been (or are being) created may be stored in various formats. The following sections describe data structures employed in the present disclosure to generate and store designs. The data structures and fields described are provided by way of example. Depending on the implementation, alternative design formats, which make use of the same, additional, fewer, and/or alternative fields may be used, and the processing described herein can be adapted for alternative formats. Further, the fields described in respect of a given data structure may be stored in one or more alternative data structures (e.g. across multiple linked data structures).

The systems and methods described herein utilize a design plan descriptor when generating candidate designs. The design plan descriptor is a temporary record that stores data retrieved, generated and selected during the design process, which is ultimately used to create the candidate designs. To assist with understanding, a partial example of a design plan descriptor is shown in table A below.

**Table A: Example design plan descriptor**

| **Field** | **Example** |
|---|---|
| Plan ID | "designPlanId": "abc123" |
| Input prompt | "Poster about my dog fluffy" |
| Category | "type": "poster" |
| Style descriptor | "name": "Vibrant" |
| Media query | "text": "A german shepard mid-jump" |
| Design template | "Templatelds": [{*T1*}, {*T2*}, {*T3*}, {*T4*}] |
| Colour palette | "colourPalette": [{*Colourpalette 1*}, {*Colourpalette 2*}, {*Colour palette 3*}, {*Colour palette 4*}] |
| Font palette | "type": [{*Fontpalette 1*}, {*Fontpalette 2*}, {*Fontpalette 3*}, {*Font palette 4*}] |
| Media | "MediaId": "239821", "378621", "87368" |
| Text content | "text": "xxxxxx", "xxxxxxxxxx", "xxxxxxxxxx" |
| Template analysis data | "Analysis data" : [{T1pre-heading, T1heading, T1body text, media item destination element of LxW}, {T2heading, T2sub-heading, media item destination element of LxW }, {T3heading, T3body text, media item destination element of LxW }, {T4heading, media item destination element of LxW}] |

In this example, the fields of the design plan descriptor include: a plan identifier (which uniquely identifies the design plan); input prompt (e.g. a prompt entered by a user to start the design creation process); a design category; a style descriptor; a media query; design template (e.g., identifiers of one or more design templates selected for the candidate designs), colour palette (e.g. identifiers of one or more colour palettes selected for the candidate designs), font palette (e.g., identifiers of one or more fonts selected for the candidate designs), text content (e.g., the text content generated for the candidate designs), and template analysis data (e.g., indicating the types of text placeholder elements present in the design templates. The design plan descriptor will be described and utilized throughout this disclosure.

In the present context, data in respect of a particular design is stored in a design record. A design record defines certain design-level attributes and includes design metadata, design format data and design elements. In the present example, the format of each design record is a device independent format comprising a set of key-value pairs. To assist with understanding, a partial example of a design record format is shown in table B below.

**Table B: Example design record**

| **Attribute** | **Example** |
|---|---|
| Design ID | "designId": "abc123" |
| Dimensions | "dimensions": {"width": 1080, "height": 1080} |
| Design type | "type": "poster" |
| Design name | "name": "Test Doc 3" |
| Design owner | "owner": 12ab34cd |
| Edit time | "edited": "xxx" |
| Background | "background": {"assetID": "M12345"} |
| Element data | "elements": [{*element 1*}, *...* {*element n*}] |

In this example, the design-level attributes include: a design identifier (which uniquely identifies the design); design dimensions (e.g. a default width and height of the design); a design type (e.g. an indicator of the type of the design, which may be used for searching and/or sorting purposes); a design name (e.g. a string defining a default or user specified name for the design); a design owner (e.g. an identifier of a user or group that owns or created the design); a most recent edit time (e.g. a timestamp indicating when the design was last edited); background (data indicating any page background that has been set, for example an asset identifier of an image that has been set as the page background, a value indicating a particular colour of a solid background fill, or data indicating an alternative background); and element data (discussed below). Additional and/or alternative design-level attributes may be provided, such as attributes regarding creation date, design version, design permissions, and/or other design-level attributes.

Element data is a set (in this example an array) of element records. Each element record defines an element (or a set of grouped elements) that has been added to the design. In this example, an element record's position in a design elements array serves to identify the element and also determines the depth or z-index of the element (or element group) in the design (e.g. an element at array index n is positioned above an element at array index *n*-1 and below an element at array index n+1). Element depth may be alternatively handled, however, for example, by storing depth as an explicit element attribute.

Generally speaking, an element defines content that has been (or is to be) added to a design - e.g. by copying/importing content from one or more asset libraries (e.g. media library, style library, etc.); by drawing/creating using one or more design tools (e.g. a text tool, a line tool, a rectangle tool, an ellipse tool, a curve tool, a freehand tool, and/or other design tools); or by otherwise adding content to a design. Various element types may include position data that defines an element's position on the page the element belongs to. In the present example, an element's position is defined by an (x, y) coordinate pair. Various element types may also include size data that defines an element's size. In the present example, an element's size is defined by a width value and a height value. Various element types also include size data that defines an element's size. In the present example, an element's size is defined by a width value and a height value. Various element types also include rotation data that defines an element's rotation. In the present example, an element's rotation is defined by a rotation value that defines a number of degrees that the element is rotate (e.g. 0 = no rotation). In the present embodiments, any rotation applied to an element is about a centre of the element.

Different types of design elements may be provided for depending on the system in question. By way of example, design element types such as the following may be provided: text elements; shape elements (for example, media items and other fill type content) and/or elements of other types. Each element will generally include a content item, metadata, and format and attribute data. For a given design element, a respective content item defines content that has the same type as the type of the field that content item corresponds to. For example, a content item corresponding to a text type design element defines text content, while a content item corresponding to an image type design element defines image content. As will be appreciated, different attributes may be relevant to different element types. For example, any element that holds visual content (e.g. an image, video, text, etc.) will typically be associated with position and size data, while such data may not be relevant to an element that holds audio media. Accordingly, different element record formats (with different attributes) may be used for different element types.

In the present disclosure, a shape element is used to hold visual content, such as an image. In this way, an image type shape element is used to hold an image-type content item. An image-type content item may, for example, be a raster image (such as a digital photograph, rendering, or an alternative raster image) or a vector graphic image. By way of example, an element record for an image type shape element is shown in table C.

**Table C: Example design element record**

| **Attribute** | **Note** | **E.g.** |
|---|---|---|
| Type | A value defining the type of the element. | "type": "IMAGE" |
| Position | Data defining the position of the element: e.g. an (x, y) coordinate pair defining (for example) the top left point of the element. | "position" : (100, 100) |
| Size | Data defining the size of the element: e.g. a (width, height) pair. | "size" : (500, 400) |
| Rotation | Data defining any rotation of the element. | "rotation" : 0 |
| Opacity | Data defining any opacity of the element (or element group). | "opacity" : 1 |
| Asset identifier | Data indicating the asset (e.g. an image) that the element holds/is used to display | "assetID": "M12345" |

Whilst the above element record is in respect of an image type element (e.g. indicating the fill is a raster graphic), shape type elements may also accommodate different types of media items and fills - e.g. a graphic fill type (indicating the fill is a vector graphic), a colour fill type (indicating the fill is a solid colour or a colour gradient), a video fill type (indicating the fill is a video), and/or other fill types.

In addition to the above-recited fields, a text element (that is used to display text content) and may include a text content field that includes the actual text (e.g. a set of one or more characters) and an attributes field ((that defines how the text characters are to be displayed). Attributes may include data such as font type, font colour, font style, font size, and/or other format data.

In certain embodiments, a text element may also include (or be associated with) text hierarchy level data that defines a hierarchy level (or levels) for the text characters. Text hierarchy levels may be represented in various ways. In some embodiments, a numeric hierarchy is used with lower values indicating text of greater significance. For example, level 0 text may correspond to a pre-heading, level 1 text may correspond to a heading, level 2 text to a sub-heading, level 3 text to body text, etc. Alternatively, text hierarchy levels may be assigned as types, e.g. pre-heading type, heading type, sub-heading type, body text type, etc. Text hierarchy levels may be determined in various ways. In some embodiments, text hierarchy levels may be explicitly defined for any text. For example, design templates, which include placeholder text elements, may explicitly include a default text hierarchy level for each text element. In alternative embodiments, text hierarchy levels may be automatically determined by processing a given design (or design template). Generally speaking, this may involve extracting the text content from a design and analysing the text to determine different text hierarchy levels based on, for example, certain key terms in the text content, certain format attributes and/or relative text (x, y coordinate) position on a page.

### Design templates

Design templates of various different design categories types may be stored in a templates library. Each design template is stored in the library as a record. Design categories may include flyer, poster, social media post, social media story, logo, presentation and video, video thumbnail, invitation. Additional and/or alternative categories are also possible. Each design template may be associated with various pre-set design attributes (such as colour, font, etc.).

In the present context, data in respect of a particular design template is stored in a design template record. A design template record defines certain design-level attributes and includes template metadata, template format data, and placeholder design elements. In the present example, the format of each design template record is a device independent format comprising a set of key-value pairs. To assist with understanding, a partial example of a design template record format is shown in table D below.

**Table D: Example design record**

| **Attribute** | **Example** |
|---|---|
| Template ID | "designId": "abc123" |
| Template style | Vibrant |
| Dimensions | "dimensions": {"width": 1080, "height": 1080} |
| Template type | "type": "poster" |
| Template name | "name": "Test Doc 3" |
| Design owner | "owner": 12ab34cd |
| Background | "background": {"assetID": "M12345"} |
| Style Attributes | "styleAttributes": {... } |
| Placeholder element data | "elements": [{*element 1*}, ... {*element n*}] |

In this example, the design-level attributes include: a template identifier (which uniquely identifies the design template); a template style (which indicates a particular design style of the template), design dimensions (e.g. a default width and height of the design); a template type (e.g. an indicator of the type or category (or sub-category) of the design, which may be used for searching and/or sorting purposes); a template name (e.g. a string defining a default or user specified name for the design); a template owner (e.g. an identifier of a user or group that owns or created the design); style attributes (data indicating any style attributes of the design, such as a colour palette, a font palette, and/or other style attributes); and placeholder element data (discussed above). Additional and/or alternative design-level attributes may be provided, such as attributes regarding creation date, design version, design permissions, and/or other design-level attributes. Various design-level attributes may be used as tags or terms (e.g. as metadata) for facilitating categorization and searching. For example, templates may be categorized and/or search based on template style, template type, template name, dimensions, and combinations thereof. Templates may also, or alternatively, be associated with other attributes (such as a keywords attribute) which can be used to store one or more keywords that can also or alternatively be used to organise and/or search/browse for templates.

As seen in table C, a design template includes placeholder elements of various types configured to receive a design element of a corresponding type. Placeholder elements may be positioned at (or configured to position source elements at) predetermined locations on a page, for example, at particular x and y coordinates and/or occupying particular ranges of pixels of a page having a predetermined resolution. Placeholder elements may also include style attributes for example, colours, fonts and the like which may be applied to design elements when populated into the placeholder element. A vast variety of design templates, placeholder elements, style attributes, and permutations thereof are possible. For example, in some embodiments, style attributes may be stored as placeholder element data of that template instead of (or in addition to) design level style attributes.

A template may include text placeholder elements (e.g. heading, subheading, body text etc.) and shape placeholder content elements (e.g. media items, shapes, etc.). Text placeholder elements may contain placeholder text and may be configured to receive corresponding text of a particular length (number of characters, words, or sentences) and/or in a particular form (paragraph, bullet points, or the like). Each of such text placeholder elements may also include one or more default style attributes that format the font including font type, font colour, and/or font size. Image placeholder elements may be configured to receive an image of a particular size, resolution, and/or aspect ratio. Shape placeholder elements may be configured to receive a shape or fill element, for example, a frame or banner. Shape placeholder elements may also include style attributes, for example, a fill or gradient of a particular colour. Any such style attributes may be default style attributes which may be overridden by the application of alternative style attributes

As one example, a design template may include placeholder elements of:
- a pre-heading placeholder element that includes placeholder text of "*Pre-heading goes here*", right justified, Calibri (light), 12 point font;
- a heading placeholder element that includes placeholder text of "*Put your main point or topic here*", bold, centred, Calibri, 18 point font;
- a sub-heading placeholder element that includes placeholder text of "*Briefly elaborate on what you intend to discuss*", underlined, left justified, Calibri, 16 point font;
- a body text placeholder element that includes placeholder text of "*Discuss your topic here*", left justified, Calibri, 14 point font;
- an image placeholder element that includes a shape element for receiving an image of a particular range of resolutions which accommodate the placement of the text placeholder elements;
- and a fill placeholder element that includes a shape element defining a banner with a fill of a particular colour or colour gradient.

Whilst the above example included a pre-heading, heading, sub-heading and single instance of body text, alternative templates with alternative text placeholder elements are possible. For example, a template may include multiple instances of placeholder body text or, alternatively, may include no placeholder text elements and include only one or more shape placeholder elements. Design templates may provide placeholder shape elements for receiving fills or images or may pre-populate the design template with images and/or shapes, for example, from a corresponding asset library.

### Design assets

As used herein, design assets refer to pre-existing design components, for example, stored in one or more asset libraries. Examples of design assets include media items, and design styles (e.g. defined sets or palettes of colours, font types, and/or other assets/asset parameters). All design assets may be stored as records in a single library or may be stored as records in respective sub-libraries, for example, a media library, a font library, a colour library, and the like.

Colour style attributes may be stored in various formats. As one example, one or more colour style attributes may be stored as a colour palette. Generally speaking, a predefined colour palette defines a set of one or more (typically complimentary) colours. For example, a given predefined colour palette may be an array of RGB (or other colour space) colour values corresponding to a predetermined number of colours (typically four to six colours).

Colour palettes and individual colours may include (or be associated with) tags or terms (e.g. as metadata) for facilitating categorization and searching. Examples of tags for colours and colour palettes may include "bold", "vibrant", "vintage", "organic", "loud", "soft", "professional", "modern" and the like. A vast number of colours, colour palettes, tags, and combinations thereof are possible.

Colour palettes may also include (or be associated with) data for associating colours in the palette with particular shapes or shape elements and/or with particular text elements having particular text hierarchy levels. As one example, association with colours in a colour palette may be configured explicitly in metadata, for example, a colour palette may include that "colour 1" is applicable to text elements of text hierarchy level 1. Additionally or alternatively, in some embodiments, tags of colours in a colour palette may be used to associate the respective colour with a text element. For example, a "bold" tagged colour in a colour palette may be associated with a text element having bold font and/or with a text hierarchy level 1 text element (e.g. a heading) intended to be bold in a design template.

Many alternative colour style attributes and colour palette structures are possible.

Font style attributes applicable to design elements may be stored in various formats. As one example, one or more font style attributes may be stored as a font palette. A predefined font palette defines a set of one or more (typically complimentary) fonts. For example, a given predefined font palette may be an array of (typically two to four) font types (e.g. Times New Roman, Helvetica, Calibri etc.) and/or font sets (e.g. Arial, Arial Black, Arial Narrow).

Font palettes and individual font may include (or be associated with) tags or terms (e.g. as metadata) for facilitating categorization and searching. Examples of tags for fonts and font palettes may include "bold", "emphasis", "calligraphy", "handwritten", "vintage", "organic", "loud", "soft", "professional", "modern" and the like. Font palettes may also include corresponding font metadata and other font attributes (e.g. font size, bold, underline, italics) for the fonts and/or each font. A vast number of fonts, font palettes, attributes, tags, and combinations thereof are possible.

Font palettes may also include (or be associated with) data for associating fonts in the palette with particular text elements having particular text hierarchy levels. As one example, association with font in a font palette may be configured explicitly in metadata, for example, a font palette may include that "font 1" is applicable to text elements of text hierarchy level 1. Additionally or alternatively, in some embodiments, tags of font in a font palette may be used to associate the respective font with a text element. For example, an "emphasis" tagged font in a font palette may be associated with a text element having bold font and/or with a text hierarchy level 1 text element (e.g. a heading) intended to be emphasised in a design template.

Many alternative font style attributes and font palette structures are possible.

In addition to data related to designs, data in respect of the usage of designs may also be maintained and stored in various formats. In one example, the systems and methods disclosed herein may store usage data with respect to search terms for searches and the categories of the corresponding designs or design templates that were selected, viewed or published in relation to the searches.

To assist with the understanding of the following description, a partial example of a usage metric record in respect of design template categories for search queries may be as follows:

**Table E: example usage metrics**

| **Search terms** | **Design category** | **Publish ratio** | **Design category** | **Publish ratio** | **Design category** | **Publish ratio** |
|---|---|---|---|---|---|---|
| "animated social media" | Social media story | 0.421 | Social media post | 0.393 | Video | 0.186 |
| "video channel logo" | Logo | 0.36 | Video | 0.355 | Video thumbnail | 0.284 |
| "social media story" | Social media story | 0.939 | Social media post | 0.041 | - | - |
| "posts" | Social media post | 0.84 | Poster | 0.135 | Post card | 0.025 |

In this example, the usage metrics map search queries (and/or terms of search queries) to the ratio of design template categories of published designs that were viewed, selected or published from such search queries. Each record in the table includes particular search terms used to search for a design template and the categories of templates selected and eventually published as designs as a result of a search using such search term(s). For each design category, in each record, a ratio of the publications of that category is also included. In this way, the usage metrics provide a category distribution as an indication of the probability that a design template of a particular category will be used when template searches include particular terms. Whilst this example illustrates up to three design categories of published designs, more or less are also possible. Furthermore, many additional and/or alternative usage metrics and data structures are also possible. For example, whilst the above is presented as a simplified table, usage metrics may be stored as JSON files.

Usage metric data may be stored and maintained (e.g. periodically updated) so that the usage of design assets, for example, design templates, media items, and style attributes can be analysed. A number of implicit conclusions can be drawn from the analysis of usage metrics. For example, if a template belonging to a particular design category is selected more frequently than templates of another category in respect of a particular search term, it may be concluded that the particular design category of templates are more relevant to the search term.

Accordingly, usage metrics are maintained so that the usage of images/graphics and/or design templates can be analyzed. For example, the usage metric data may also be utilized in the present disclosure to determine the intended category for a design template based on an input prompt. These functions will be described in more detail in the following sections.

### Example systems

The techniques disclosed herein are described in the context of a digital design platform that is configured to facilitate various operations concerned with digital designs. In the context of the present disclosure, these operations relevantly include automatically creating a design. A digital design platform may take various forms. In the embodiments described herein the digital design platform is a client-server type platform (e.g. one or more client applications and one or more server applications that interoperate to perform the described techniques). The techniques described herein can, however, be performed (or be adapted to be performed) by a stand-alone digital design platform (e.g. an application or set of applications that run on a user's computer processing system and perform the techniques described herein without requiring server-side operations).

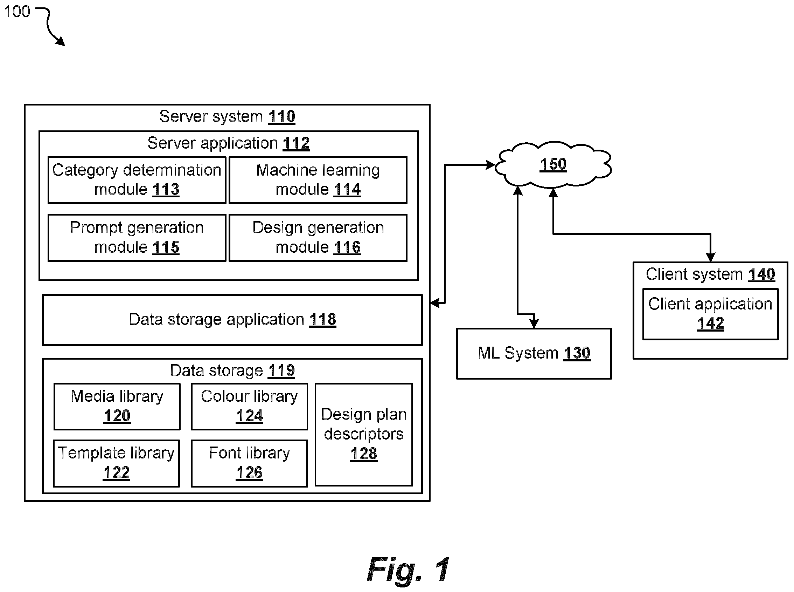

FIG. 1 depicts an example networked environment 100 in which various features of the present disclosure may be implemented. The networked environment 100 includes a server system 110, a ML system 130, and a client system 140, which operate together to perform the operations described herein.

The systems 110-140 communicate with one another via one or more communication networks 150 (e.g., the Internet). For example, the client system 140 communicates with the server system 110 via public internetwork, whereas the server system 110 may communicate with the ML system 130 via a local or public area network.

The server system 110 is a system entity that hosts one or more computer applications and/or content. The server system 110 may include one or more server computing systems or nodes for hosting a server application 112 and one or more storage devices (e.g., data store 119) for storing application specific data. An example of a server application hosted by the server system 110 includes a digital design application (e.g., Canva designs).

The server system 110 may execute to provide a client application endpoint that is accessible over the communication network 150. In some examples, the server system 110 is a web server, which serves web browser clients and receives and responds to HTTP requests. In another example, the server system 110 is an application server, which serves native client applications and is configured to receive, process, and respond to specifically defined API calls received from those client applications. The server system 110 may include one or more web server applications and/or one or more application server applications allowing it to interact with both web and native client applications.

While a single server architecture has been described herein, it will be appreciated that the server system 110 can be implemented using alternative architectures. For example, in certain cases a clustered architecture may be used where multiple server computing instances (or nodes) are instantiated to meet system demand. Communication between the applications and computer processing systems of the server system 110 may be by any appropriate means, for example direct communication or networked communication over one or more local area networks, wide area networks, and/or public networks (with a secure logical overlay, such as a VPN, if required). Conversely, in the case of small enterprises with relatively simple requirements the server system 110 may be a stand-alone implementation (i.e. a single computer directly accessed/used by the client).

The server application 112 (and/or other applications of server system 110), in conjunction with client application 142, facilitates various functions related to digital designs. These may include, for example, design creation, editing, organisation, searching, storage, retrieval, viewing, sharing, publishing, and/or other functions related to digital designs. The server application 112 may also facilitate additional, related functions such as user account creation and management, user group creation and management, and user group permission management, user authentication, and/or other server side functions.

To perform the functions described herein, the server application 112 includes a number of software modules, which provide various functionalities and interoperate to automatically generate designs. These modules are discussed below and include: a category determination module 113; a machine learning module 114; a prompt generation module 115; and a design generation module 116.

In the present embodiment, the category determination module 113 is configured to determine one or more design categories according to an input prompt. For example, the category determination module 113 may process an input prompt and determine a design category associated (or for association) with the input prompt. The category determination module 113 may process inputs as a full string of characters, as individual words (e.g. sets of characters delineated by spaces), and/or groups of words or sub-queries within inputs.

The ML module 114 is configured to communicate with the ML system 130 over network 150. In particular, it is configured to provide one or more input prompts to the ML system 130 and receive one or more outputs from the ML system 130. The outputs may include design outlines and design content.

The prompt generation module 115 is configured to receive input prompts and generate design outline prompts and design content prompts for the ML system 130.

The design generation module 116 is configured to receive design outlines, design categories, and design content from various modules and select design assets (such as design templates, fonts and colours) based on the design outlines and categories and also transfer design elements from the design content and design assets into the selected design templates to generate one or more design The functionality of these modules will be described in detail later.

The server 110 may further include a data storage application 118, which is configured to receive and process requests to persistently store and retrieve, to and from data store 119, data relevant to the operations performed/services provided by the server application 112. Such requests may be received from the server application 112, other server environment applications, and/or (in some instances) directly from client applications such as 142.

The data storage application 118 may, for example, be a relational database management application or an alternative application for storing and retrieving data from data store 119. Data store 119 may be any appropriate data storage device (or set of devices), for example one or more non transient computer readable storage devices such as hard disks, solid state drives, tape drives, or alternative computer readable storage devices. Furthermore, while a single instance of data store 119 is described, server system 110 may include multiple instances of data storage.

The data store 119 stores data relevant to the operations performed/services provided by the server application 112. In particular, it stores asset libraries such as a template library 122 (e.g. a library of design templates records for various design categories), a font library 126 (e.g. a library of fonts and font palettes), a colour library 124 (e.g. a library of colours and colour palettes), and a media library 120 (e.g. library of media items such as images and videos), usage metrics (e.g. table D), user account data, design data (e.g., as shown in tables A and B), and/or other data relevant to the operation of the server application 112. In addition, the data store 119 may also maintain a cache that stores design plan descriptors 128 while candidate designs are being generated. Once candidate designs are generated and provided to the client device, the design plan descriptors can be discarded and the cache can be cleared.

The ML system 130 hosts one or more generative ML models that may be configured to generate outputs based on input prompts. In particular, the ML system 130 may be configured to receive a first input prompt (e.g., a design outline prompt) and generate a design outline based on the first input prompt. It also receives a second input prompt (e.g., a design content prompt) and is trained to generate design content based on the second input prompt.

In some embodiments, the ML system 130 may be a large language model (LLM) that is trained as a general purpose ML model that can be used to generate different types of text based outputs. In the present case, if a general purpose ML model is used, it is additionally trained to perform specific tasks. For example, the general purpose ML model may be trained to generate text (e.g. design outlines and design content described above) from a prompt. In other embodiments, the ML model may be a more specific model that is trained to generate the outputs described above.

Further still, in some examples, the ML system 130 may be associated with and owned by the same party that operates the server system 110. In this case, the ML system 130 may be part of the server system 110. In other examples, the ML system 130 may be owned or operated by a third party that is independent to the party that owns or operates the server system 110. Examples of third party LLMs include OpenAI's ChatGPT4, and Google's Bard.

The client system 140 may be a desktop computer, laptop computer, tablet computing device, mobile/smart phone, or other appropriate computer processing system. Client system 140 hosts a client application 142 which, when executed by the client system 140, configures the client system to provide client-side functionality/interact with server system 110 (or, more specifically, the server application 112 and/or other applications provided by the server system 110). Via the client application 142, and as discussed in detail below, a user can access and make use of the various techniques and features described herein - e.g., the user can input prompts to generate designs and view or preview designs. Client application 142 may also provide a user with access to additional design related operations, such as creating, editing, saving, publishing, sharing, and/or other design related operations.

The client application 142 may be a general web browser application which accesses the server application 112 via an appropriate uniform resource locator (URL) and communicates with the server application 112 via general world-wide-web protocols (e.g. http, https, ftp) over communications network 150. Alternatively, the client application 142 may be a native application programmed to communicate with server application 112 using defined API calls and responses. A given client system such as 130 may have more than one client application 142 installed and executing thereon. For example, a client system 140 may have a (or multiple) general web browser application(s) and a native client application.

The present disclosure describes various operations that are performed by server application 102 and client application 142. However, operations described as being performed by a particular application (e.g. server application 112) could be performed by (or in conjunction with) one or more alternative applications (e.g. client application 142), and/or operations described as being performed by multiple separate applications could in some instances be performed by a single application.

In the present example, server system 110 is configured to perform the functions described herein by execution of a software application (or a set of software applications) - that is, computer readable instructions that are stored in a storage device (such as non-transient memory 210 described below) and executed by a processing unit of the system 200 (such as processing unit 202 described below). Similarly, client system 140 is configured to perform functions described herein by execution of software application 142 stored in a storage device and executed by a processing unit of a corresponding system.

The techniques and operations described herein are performed by one or more computer processing systems. By way of example, client system 140 may be any computer processing system which is configured (or configurable) by hardware and/or software - e.g. client application 142 - to offer client-side functionality. A client system 140 may be a desktop computer, laptop computer, tablet computing device, mobile/smart phone, or other appropriate computer processing system. Similarly, the server application 112 is also executed by one or more computer processing systems (the server system 110).

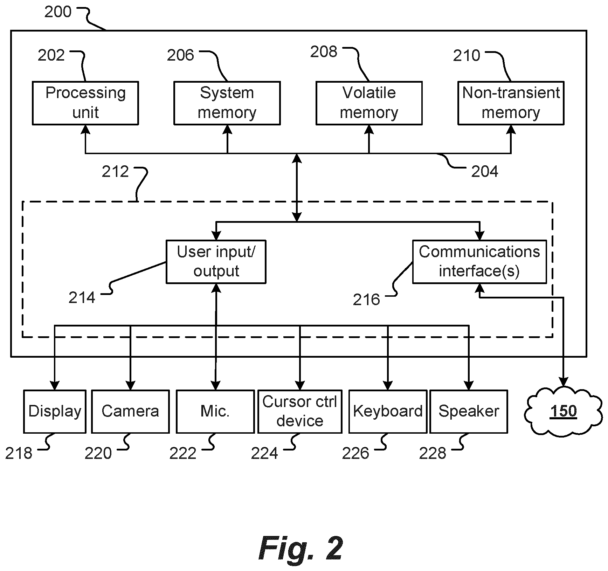

FIG. 2 provides a block diagram of a computer processing system 200 configurable to implement embodiments and/or features described herein. For example, systems 110 and/or 200 of FIG. 1 may be (or include) a computer processing system such as that shown in FIG. 2 (though alternative architectures are possible).

System 200 is a general purpose computer processing system. It will be appreciated that FIG. 2 does not illustrate all functional or physical components of a computer processing system. For example, no power supply or power supply interface has been depicted, however system 200 carries a power supply or is configured for connection to a power supply (or both). It will also be appreciated that the particular type of computer processing system will determine the appropriate hardware and architecture, and alternative computer processing systems suitable for implementing features of the present disclosure may have additional, alternative, or fewer components than those depicted.

Computer processing system 200 includes at least one processing unit 202. The processing unit 202 may be a single computer processing device (e.g. a central processing unit, graphics processing unit, or other computational device), or may include a plurality of computer processing devices. In some instances, where a computer processing system 200 is described as performing an operation or function all processing required to perform that operation or function will be performed by processing unit 202. In other instances, processing required to perform that operation or function may also be performed by remote processing devices accessible to and useable (either in a shared or dedicated manner) by system 200.

Through a communications bus 204 the processing unit 202 is in data communication with a one or more machine readable storage (memory) devices, which store computer readable instructions, and/or data, which are executed by the processing unit 202 to control operation of the processing system 200. In this example, system 200 includes a system memory 206 (e.g. a BIOS), volatile memory 208 (e.g. random access memory such as one or more DRAM modules), and non-transient memory 210 (e.g. one or more hard disk or solid state drives).

System 200 also includes one or more interfaces, indicated generally by 212, via which system 200 interfaces with various devices and/or networks. Other devices may be integral with system 200, or may be separate. Where a device is separate from system 200, the connection between the device and system 200 may be via wired or wireless hardware and communication protocols, and may be a direct or an indirect (e.g. networked) connection.

Depending on the particular system in question, devices to which system 200 connects include one or more input devices to allow data to be input into/received by system 200 and one or more output devices to allow data to be output by system 200. Example devices are described below, however it will be appreciated that not all computer processing systems will include all mentioned devices, and that additional and alternative devices to those mentioned may well be used.

For example, system 200 may include or connect to one or more input devices by which information/data is input into (received by) system 200. Such input devices may, for example, include a keyboard, a pointing device (such as a mouse or trackpad), a touch screen, and/or other input devices. System 200 may also include or connect to one or more output devices controlled by system 200 to output information. Such output devices may, for example, include one or more display devices (e.g. a LCD, LED, touch screen, or other display devices) and/or other output devices. System 200 may also include or connect to devices which act as both input and output devices, for example touch screen displays (which can receive touch signals/input and display/output data) and memory devices (from which data can be read and to which data can be written).

By way of example, where system 200 is an end user device (such as system 140), it may include a display 218 (which may be a touch screen display), a camera device 220, a microphone device 222 (which may be integrated with the camera device), a cursor control device 224 (e.g. a mouse, trackpad, or other cursor control device), a keyboard 226, and a speaker device 228.

System 200 also includes one or more communications interfaces 216 for communication with a network, such as network 150 of FIG. 1. Via the communications interface(s) 216, system 200 can communicate data to and receive data from networked systems and/or devices.

System 200 may be any suitable computer processing system, for example, a server computer system, a desktop computer, a laptop computer, a netbook computer, a tablet computing device, a mobile/smart phone, a personal digital assistant, or an alternative computer processing system.

System 200 stores or has access to computer applications (which may also be referred to as computer software or computer programs). Such applications include computer readable instructions and data which, when executed by processing unit 202, configure system 200 to receive, process, and output data. Instructions and data can be stored on non-transient machine readable medium such as 210 accessible to system 200. Instructions and data may be transmitted to/received by system 200 via a data signal in a transmission channel enabled (for example) by a wired or wireless network connection over an interface such as communications interface 216.

Typically, one application accessible to system 200 will be an operating system application. In addition, system 200 will store or have access to applications which, when executed by the processing unit 202, configure system 200 to perform various computer-implemented processing operations described herein. For example, and referring to the networked environment of FIG. 1 above, server system 110 includes one or more systems 200, which run a server application 112. Similarly, client system 140 runs a client application 142. Application 142 is configured to display an input user interface (UI), e.g. on display 218. Server application 112 may communicate with client application 142 to display the input UI using the user interface module 134. The input UI provides a mechanism for a user to generate designs, for example, by searching for and selecting template designs, editing and adding content to such template designs, and outputting designs by saving, publishing, or otherwise outputting the design. For example, a user may commence generating a design by entering a search query for a design template such as "welcome poster" wherein the UI will present the user with various design templates (e.g. poster type design category templates) suitable for poster category designs. The user may then view templates, select a template begin editing a design starting from the template, and publish a design completed from the template. Such searches, selections, publications, actions and events may be saved as usage metrics, for example, by the metrics model 103.

In the present disclosure, the input UI provides a mechanism for a user to automatically generate a design by inputting a prompt for a design and to edit, and output such designs. Various input UI's are possible. One example is graphical user interface (GUI) and the UI will be envisioned as a GUI in the following description. While a GUI is provided as an example, alternative input UI's are also possible. As another example, the input UI may be a command line interface type UI that a user can use to provide prompts, media items and media item identifiers (e.g. file locations or other identifiers) and selections that are to be used in the design generation. The UI also allows a user to access and cause other functionality described herein to be performed. By way of example, the UI may include a prompt input region, which can be used by a user to input a prompt. The UI may also include functionality to display design options to a user for selection, for example the display of candidates, explained further below.

### Example methods

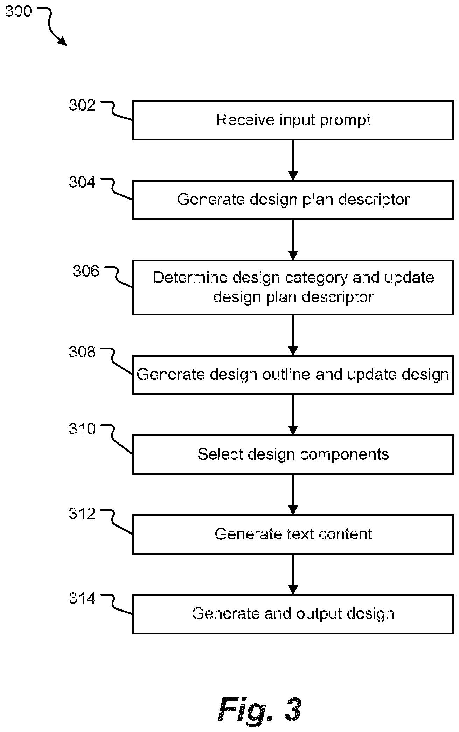

Turning to FIG. 3, a method 300 for automatically generating one or more candidate designs will be described. The operations of method 300 will generally be described as being performed by application 112 (and the various associated modules) running on system 110. The operations could, however, be performed by one or more alternative applications running on system 110 and/or one or more alternative computer processing systems.

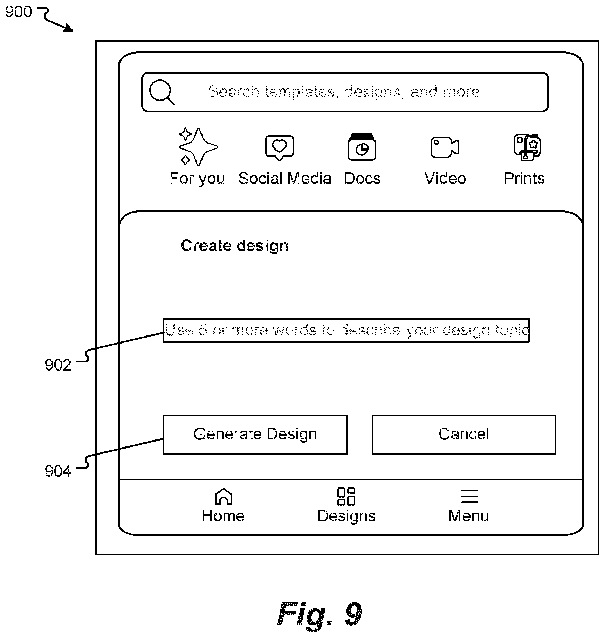

Application 112 may be configured to perform method 300 in response to detecting one or more trigger events. As one example, application 112 may communicate with application 142 (e.g. via network 150) to cause application 142 to display a user interface), e.g., user interface 900 displayed in Fig. 9. The UI 900 includes a prompt input region 902. The prompt input region 902 may include a text field with placeholder text, for example, of "Use 5 or more words to describe your design" or alternative text, which directs a user to input their prompt in this region 902. The UI further includes an interactive control, e.g., "generate design" control 904. The method 300 may commence when a user inputs a user prompt in the prompt input region 902 and then activates the interactive control 904.

At 302, a request for generating a design is received at the server application 112. In one example, once the user activates the control 904, the client application 142 creates a request for generating one or more candidate designs and passes the user prompt along with the request to the server application 112. The user prompt may be in the form of a text string, for example, of 5 or more words.

At 304, the application 112 creates a design plan descriptor 128 for the received request. In particular, it may generate a unique design plan identifier and store the design plan identifier in the design plan descriptor 128 along with the user input received as part of the request. An example design plan descriptor 128 at this stage is displayed below in table F -

**Table F - Example design plan descriptor after step 304**

| | |
|---|---|
| **Design plan identifier** | 273278 |
| **User prompt** | "A welcome poster to Austria" |

At 306, the category determination module 113 determines a category of the candidate designs based on the input prompt. The category determination module 113 may store a list of design categories in the data store 119. In some examples, the user prompt may explicitly mention the design category. In such examples, the category determination module 113 may identify a design category by parsing the input prompt and comparing terms from the input prompt with the list of design categories to determine a match.

In other examples, the user prompt may not explicitly mention a design category. In such cases, the category determination module 113 may utilize different techniques to identify the design category. In one example, it may do so based on usage metrics (e.g., shown in table E). For example, metrics category determination module 113 may look up usage metrics (e.g., shown in table E) for search queries including the term "posts" and determine which category of designs have the largest ratio of published designs for that term.

In other examples, the category determination module 113 may include or utilize an ML model that is trained to identify a design category given an input prompt. In this case, the ML model may be trained on copious amounts of input prompts or search terms that are labelled with the appropriate design category. After sufficient amount of learning, the ML model is trained to generate a design category (e.g., from a set of design categories) for any given input prompt with reasonable accuracy.

The category determination module 104 may combine various category determination techniques to determine the design category of an input. For example, the category determination module may apply weighted relevance scores of design categories to input terms based on the number of words in the input, which match words in the design category. Relevance of design categories to input terms may also be assigned (and/or weighted) based on the ratio of publications of designs in a category resulting from respective input terms. Whilst the present example is in respect of a single category, in alternative embodiments, the category determination module may determine multiple categories or a range of categories as relevant to the input prompt and may determine multiple categories or a category distribution in respect of the design.

Once the category determination module 113 determines the category (or categories) for the design, it updates the design plan descriptor 128. An example of the design plan descriptor at this stage is displayed in table G below -

**Table G - Example design plan descriptor after step 306**

| | |
|---|---|
| **Design plan identifier** | 273278 |
| **User prompt** | "A welcome poster to Austria" |
| **Category** | Poster |

At 308, the application 112 generates a design outline for the one or more candidate designs. In some embodiments, this includes communicating the user prompt to the ML system 130 along with a request to generate the design outline. The application 112 receives the design outline from the ML system 130 and populates the design plan descriptor with the received design outline. As described previously, the design outline includes a style descriptor and a media query.

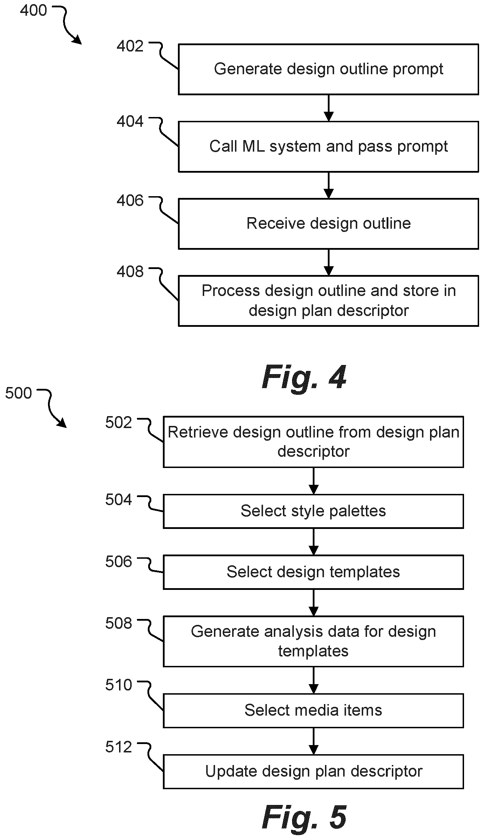

Method step 308 will be described in more detail with reference to Fig. 4. An example design plan descriptor 128 at this stage is displayed in table H below -

**Table H - Example design plan descriptor after step 306**

| | |
|---|---|
| **Design plan identifier** | 273278 |
| **User prompt** | "A welcome poster to Austria" |
| **Category** | Poster |
| **Style descriptor** | Style descriptor : alpine landscapes and lush nature |
| **Media query** | Media query : Majestic Austrian Alps |

At 310, once the design outline has been generated, the application 112 generates, selects or retrieves design components for the candidate designs. This may be done, for example, by selecting one or more design templates for the candidate designs and selecting design assets (e.g. media items, and style attributes) based on the design outline generated at step 304 from one or more asset libraries. This step will be described in more detail with reference to Fig. 5.

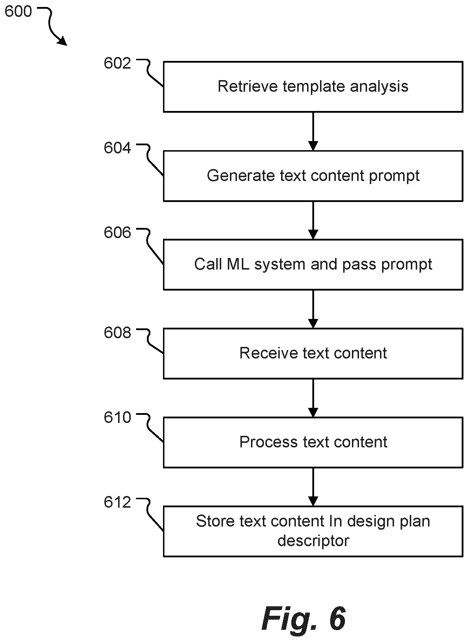

At step 312, the application 112 generates text content for the design based on the design outline and selected design templates. In some embodiments, to do so, the application 112 generates a second input prompt based on the design outline and design assets and communicates this prompt to the ML system 130 along with a request for text for the design. The application 112 receives the text content from the ML system 130 and populates the design plan descriptor and in particular a text content field with the received text content. Method step 312 will be described in more detail with reference to Fig. 6.

An example design plan descriptor 128 at this stage is displayed in table A.

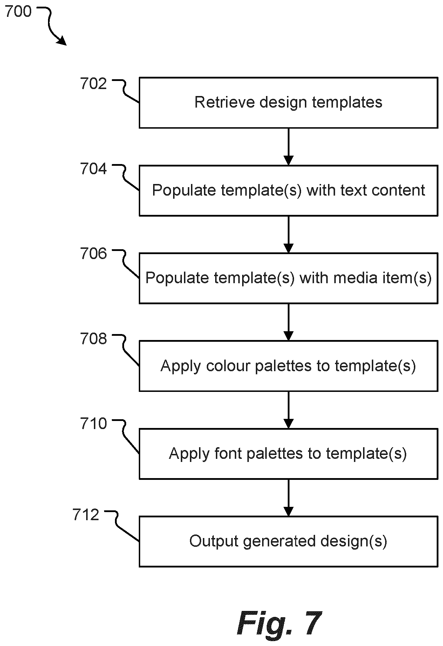

The method 300, may then proceed to the step 314, where the one or more candidate designs are generated and communicated to the client system 140 for display thereon. At step 314, the application 112 inspects the design plan descriptor 128, and transfers design elements such as the text content and the media items, and applies style attributes such as the fonts and colours to the selected design templates to create the candidate design records. These steps will be further outlined below, with reference to FIG. 7. Whilst method 300 is described sequentially, it is also possible to perform steps of the process in alternative orders.

FIG. 4 illustrates an example method 400 for performing method step 306, i.e., generating a design outline, according to embodiments of the present disclosure. The method 400 commences at step 402, where the prompt generation module 115 is provided the user input prompt received at step 302 and generates a design outline prompt. The content of the design outline prompt will depend on the type of ML system 130 being used. If the ML system 130 is a general purpose LLM, the design outline prompt includes the user input prompt and configuration data, which provides instructions to the ML system 130 to generate the page outlines. In case the ML system 130 includes a specific ML model that has already been trained for the specific task of generating design outlines, the design outline prompt may only include the user input prompt.

The precise format of the configuration data depends on a variety of factors, including the type of LLM (e.g., configuration data for use with OpenAI's ChatGPT may differ from the configuration data required for Google's Bard), the training mechanism of the ML model, and the content of the user input prompt (and/or other available data).

In one example, the configuration data for the page outline prompt may include a brief description of the task (e.g., to generate design outlines for designs), parameters for the task (e.g., output format, number of elements, tone of the output, rules, etc.), and one or more training examples of input prompts and the design outlines the ML system 130 is expected to generate based on those input prompts. The table I below shows examples of design outline configuration data that can be used.

**Table I - Example design outline configuration data**

| | |
|---|---|
| Description of task: | *Generate design outlines based on a design brief called PROMPT.* |
| Parameters: | *"Be helpful and creative, and do not use offensive language."* |
| | *Each design outline uses the structure: "style descriptor: describes the thematic style of the design " and "media query: query to search a stock photo library for media ".* |
| | " |
| | *"Output design outlines in the order of style descriptor then media query"; "Output one style descriptor "; "Output one media query"; "Only specify colour if mentioned in PROMPT";* |
| Examples: | *User prompt: "A welcome poster to Austria"* |
| | *ML System Output:* |
| | *Style descriptor: elegance, rich history and culture* |
| | *Media query: Historic architecture of Vienna* |

It will be appreciated that the configuration data may include many alternative components and template prompts and that many alternative approaches to generating a prompt are possible. For example, the parameters component may specify the generation of multiple design outlines, and/or that each design outline includes multiple style descriptors and/or multiple media queries. In one example, the configuration data may be (or include) a single pre-assembled template prompt - e.g. a string that includes all the relevant set text components. Alternatively, separate prompts may be generated including separate components and combinations thereof. The ML system 130 can thus be configured by providing the configuration data as a prompt, part of a prompt, or series of prompts.

In some embodiments, the same configuration data may be used to configure the ML system 130 to generate page outlines every time. In such cases, the design outline configuration data may be predefined and stored in data store 119. In other embodiments, the configuration data may vary (e.g., depending on user requirements). For example, a user may provide a tone for the design (e.g., funny) that overrides the preset tone for the design in the configuration data. In this case, the parameters of the configuration data may be updated to include the user input tone before the configuration data is added to the design outline prompt.

At step 402, the prompt generation module 115 retrieves the configuration data from the data store 119, determines whether the configuration data needs to be updated (e.g., based on the received user input), and combines the configuration data with the user input prompt to generate the page outline prompt. In one embodiment, the prompt generation module 115 generates the design outline prompt by constructing a text string from one or more component parts of the configuration data and the user input prompt (e.g. by concatenating the component parts and the user input prompt together).

At step 404, once the design outline prompt is generated, the prompt generation module 115 communicates the design outline prompt to the ML module 114. The ML module 114 then communicates the design outline prompt to the ML system 130.

By way of the design outline configuration data, the ML system 130 is cued to generate design outlines based, in part, on the user prompt. Based on the example configuration data shown in table I, the ML system 130 is cued to generate a style descriptor and a media query. The style descriptor may be a string of text characters that describes a thematic style for a design, based in part on the user prompt. The media query may be a string of characters, which describes a suitable media item for a design, based in part on the user prompt.

At 406, the ML module 114 receives the design outline output by the ML system 130 as a string of output text characters, referred to as a completion. An example of the output generated by the ML system 130 at this point for a user input, "A welcome poster to Austria", is provided in the format "Style descriptor": {} and "Media query": {} in table J below -

**Table J: Example design outline**

| |
|---|
| "Style descriptor": {alpine landscapes and lush nature}, "Media query": {Majestic Austrian Alps} |

In the above example, a single instance of the style descriptor and the media query is provided. In alternative embodiments, a design outline may include multiple style descriptors and/or multiple media queries. The multiple style descriptors and/or multiple media queries may be suitably generated by defining that requirement in the configuration data parameters. Additionally or alternatively, the same user prompt and design outline configuration prompt may be provided to multiple LLMs (or instances of LLMs) having varying parameters such as different temperature settings, training sets, or few-shot examples in order to generate multiple design outlines having variance in their respective style descriptors and/or media queries. As will be outlined further below, such style descriptors and media queries are used in the retrieval and generation of design components. Accordingly, controlled varying of style descriptors and media queries may enable greater variety with design components whilst remaining aligned with an original input prompt.

At step 408, the design outline is added to the design plan descriptor 128. In some embodiments, design generation module 116 may parse or process the text of the completion based on the format rules specified in the configuration data to identify the style descriptor and media query. For example, it may parse the completion and identify the term "style descriptor" or "media query" and then identify a string of characters following a colon (":") up until a carriage return. Alternative parsing, text analysis and processing techniques are also possible to identify the style descriptor and/or media query in the design outline.

Once the individual components of the design outline are determined, the design generation module 116 stores the style descriptor and the media query in the design plan descriptor 128 as described above. The method 400 then ends.

It will be appreciated that in method 400, it is presumed that the configuration data is provided to the ML system 130 each time new page outlines are required. However, this need not be the case in all implementations. In other implementations, the design outline configuration data may be provided to the ML system 130 each time an instance of the ML system 130 is invoked. If the same ML system instance is then used for subsequent design outline requests, the configuration data need not be submitted to the ML system 130 again as the ML system can remember the configuration data it has been provided previously and utilize that configuration data for subsequent design outline requests. Once the ML system 130 instance is closed or exited, it may flush the configuration data and the server application 112 may need to resend the configuration data along with a page outline request when a new instance of the ML system 130 is invoked.

Further still, in method 400, it is presumed that the ML system is a general purpose LLM that has not previously been trained or configured to provide page outlines in the required manner. However, this need not be the case in all implementations. In some implementations, a specific purpose ML system may be adopted that has been trained and/or fine tuned using copious amounts of training data of input user prompts and desired output design outlines. There is no need to provide additional configuration data for such specifically trained ML systems 130 and in such cases, the design outline prompt may simply include the user prompt.

FIG. 5 illustrates an example method 500 for performing the method step 310 (i.e., retrieving design components).

Method 500 commences at step 502, where the design generation module 116 retrieves the style descriptor and/or a media query from the design plan descriptor 128.

At step 504, the design generation module 116 selects one or more style palettes for the design. Selection of the style palettes is based on the retrieved style descriptor. In some embodiments, the style palettes include one or more colour palettes and one or more font palettes. The colour palettes may be selected, e.g., by performing a search in the 'tags' metadata field in the colour palette library using one or more style descriptors as a search term. Similarly, the font palettes may be selected, e.g., by performing a search in the 'tags' metadata field in the font library using the style descriptor as a search term. It will be appreciated that multiple colour or font palettes may be associated with the same tags and therefore the design generation module 116 may select more than one colour palette and/or font palette for the style descriptor at this stage. In some embodiments, only a colour palette or only a font palette is selected. The number (and type) of style palettes selected may depend on the manner the design generation module 116 is configured.

Further, in case a design plan descriptor includes multiple style descriptors, and a search is performed for style palettes for each of those style descriptors separately, it is possible that the same style palette is selected for different style descriptors (e.g., because a style palette is associated with multiple tags). In some cases, this may not be an issue and the same style palette may be selected for different style descriptors. In other cases, if it is desirable to create multiple designs based on the input prompt with many varying design styles, the design generation module 116 may be configured to discard a duplicate style palette and replace it with another style palette that substantially matches the corresponding style descriptor.

At step 506, the design generation module 116 retrieves one or more design templates based on the design category and the style descriptor. In some embodiments, the design generation module 116 may perform a search in the 'design type' field in the design template records stored in the templates library 122 using the category of the design identified at step 306 to obtain a first subset of results. It may then perform a search in the style field of the template records in this subset of results using the style descriptor to identify one or more design templates for the one or more candidate designs. In other embodiments, the design generation module 116 may formulate a search string that combines the style descriptor and the design category and use this search string to identify relevant design templates, for example, based on the presence of search terms in template metadata.

It will be appreciated that more than one design template may match the style descriptor and/or the category type. In such cases, the design generation module 116 may be configured to select a predetermined number (e.g., 1, 2, 5, etc.) of design templates from the matching results. Further, if the design plan descriptor includes multiple style descriptors, the design template may select one or more design templates for each of the style descriptors.

Furthermore, in case a design plan descriptor includes multiple style descriptors, and a search is performed for design templates for each of those style descriptors separately, it is possible that the same design template is selected for different style descriptors (e.g., because a design template is associated with multiple style categories). In some cases, this may not be an issue and the same design template may be selected for different style descriptors. In other cases, if it is desirable to create multiple designs based on the input prompt with many varying design styles, the design generation module 116 may be configured to discard a duplicate design template and replace it with another design template that substantially matches the corresponding style descriptor.

At step 508, design generation module 116 generates analysis data based on the selected design templates. Generating analysis data includes retrieving (e.g. from the template library 122) additional metadata in respect of the selected design templates and analysing the respective metadata. For example, design generation module 116 may analyse the template metadata to determine the presence and type of various placeholder elements, such as placeholder text elements and placeholder shape elements, included in each design template.

Analysis data may be hierarchical, that is, each of the elements of each of the templates may be considered an analysis object and analysed to determine analysis data of each element. For example, each element of a template may be analysed to determine if it is a text element or a shape element. Shape elements may be analysed to determine if they are configured to receive a media item, colour fill, or alternative fill type content. For example, destination media item elements may be analysed as being configured to receive an image and/or a video. Text elements may be analysed to determine a text hierarchy level, for example, level 0, level 1, level 2, or level 3, and/or as being one of a pre-heading, a heading, a sub-heading, or body text. The analysis data of all design elements of a template may be aggregated to generate analysis data of the respective template.

Analysis data may be determined by processing and identifying attributes explicitly defined in metadata of respective elements. For example, a placeholder shape element of a template may have an element record explicitly defining that its expected fill type is an image type fill. Accordingly, design generation module 116 may generate analysis data of such an element being an image-type placeholder element. Similarly, depending on the particular design template, a placeholder text element record may explicitly define a respective text hierarchy level. Alternatively, design generation module 116 analyses text elements of templates in order to determine text hierarchy levels. Such determinations may be based on one or more of, for example: a default font size defined in the element record for the text element; relative font size between font sizes defined for text elements in the template; a (x, y) position of the element, a relative (x, y) position of elements, particular terms in placeholder text of the element; and other factors. As one example, a text element with placeholder text of "Heading goes here" or "Put your main topic here" may be determined to be text element with a text hierarchy level of heading, and a text element with an x coordinate higher than the heading element may be determined to be a text element with a text hierarchy level of pre-heading. It will be appreciated that many alternative processes for determining analysis data are also possible.

At step 510, the design generation module 116 selects one or more media items from the media library based on the media query present in the design plan descriptor. To this end, the design generation module 116 uses the media query to search the media library to identify one or more media items that matches the media query. In one example, the design generation module 116 may pass the media query to the data storage application 118, which performs a search in the media library 120 for one or more media items that match the media query. The data storage application 118 communicates the identified media items to the design generation module 116.

The design generation module 116 subsequently selects a predetermined number of media item from the results. The predetermined number may be preset and based on the configuration of the design generation module 116. In some examples, the number of media items selected may depend on the number of design templates selected at step 506 and the number of image placeholder elements detected in the selected design templates at step 508.

In one example, the design generation module 116 selects the first n media items in the list of results (as they may likely have the highest match percentage to the media query). In other examples, the design generation module 116 may randomly select n media items from the list of results (in case all the media items equally match the media query). In some examples, the design generation module 116 may select n media items amongst media items having dimensions and/or aspect ratios within a predetermined range, for example, as generally compatible with templates for the determined design category (or categories). Additionally or alternatively, the media items may be selected based on a weighting of relevance (e.g. order in the returned list of search results) versus their respective dimensions and/or aspect ratio.

At 510, the design elements (e.g., media items), style attributes (e.g., colour and font palettes), and the design templates retrieved at steps 502-506 and 510 along with the analysis data determined at step 508 are stored in the design plan descriptor 128. In some embodiments, the design generation module 116 may store the design asset identifiers and analysis data in a design components field in the design plan descriptor. In other examples, the individual design components may be stored in separate fields such as colour palettes, font palettes, media items, design templates, template analysis data, etc.

Whilst method 500 is described sequentially, this may not be the case in all implementations. In some cases, method steps 504, 506, and 508 may be performed substantially simultaneously.

FIG. 6 illustrates an example method 600 for performing step 312 (i.e., generating text content). In some embodiments, the text content may be generated as replacement text for placeholder text elements, for example, in each of the design templates in the design plan descriptor. To so do, the method 600 commences at step 602, where the design generation module 116 retrieves design template analysis data from the design plan descriptor. In particular, it may retrieve analysis data corresponding to placeholder text elements for each of the design templates in the design plan descriptor.

At step 604, the design generation module 116 passes the retrieved design template analysis data along with the input prompt to the prompt generation module 115. The prompt generation module 115 generates one or more text content prompts based on the received data.

In some examples, the text content prompts include configuration data and prompt data. The configuration data may include a brief description of the task (e.g., to generate text content for a design), parameters for the task (e.g., output format, tone of the output, rules, etc.), and one or more training examples of input prompts and the text content the LLM is expected to generate based on the input prompts.

The table K below shows examples of design outline configuration data that can be used.

**Table K - Example design outline configuration data**

| | |
|---|---|
| Description of task: | *Generate replacement text content for a design given a PROMPT and PLACEHOLDERTEXT.* |
| Parameters: | *"Be helpful and creative, and do not use offensive language."* |
| | *"the output must be formatted as: "- pre-heading : the pre-heading text content";* "- *heading: the heading text content"; "-sub-heading: the sub-heading text content";* "- *body text: the body text content"."* |
| | *"The pre-heading should be a 3 to 5 word phrase.* "; *"The heading should be a 3 to 5 word phrase.* "; *The sub-heading should be a 5 to 12 word sentence.* " *"Body text should be a paragraph with maximally 150 characters. "."* |
| Examples: | Example input: |
| | PROMPT: "A social media post for the magic design software architecture page" |
| | PRE-HEADING PLACEHOLDERTEXT: "Pre-heading goes here" |
| | HEADING PLACEHOLDERTEXT: "Put your main point or topic here" |
| | SUB-HEADING PLACEHOLDERTEXT: "Briefly elaborate on what you intend to discuss" |
| | BODYTEXT PLACEHOLDERTEXT: "Discuss your topic here" |
| | PRE-HEADING output: |
| | "Pre-heading : *Discover the magic of design"* |
| | HEADING output: |
| | "Heading : Join Us and explore the architecture of our software" |
| | SUB-HEADING output: |
| | "Sub-heading : from wireframe to final product, our software streamlines your design process" |
| | BODY TEXT output: |
| | "Body text: The Magic Design feature allows users to ... " |

It will be appreciated that the configuration data may include many alternative components. For example, the configuration data may be (or include) a single pre-assembled template prompt - e.g. a string that includes all the relevant set text components.

In one example, the parameters of the configuration data may be different for different types of placeholder text elements. For example, if a placeholder text element is of a `heading' type and another placeholder text element is of a 'body' type, the specific text format required for each of these element types may be different. Accordingly, in some embodiments, the prompt generation module 115 identifies the placeholder text element types for each design template from the analysis data and updates the configuration data such that the parameters section of the configuration data matches the placeholder text element types for that design template. For example, if a given design template only includes a heading and body placeholder elements, the configuration data parameters may be updated to include instructions such as, "*the output must be formatted as:* "- *heading: the heading text content";* "- *body text: the body text content".* Alternatively, if a given design template includes a pre-heading and sub-heading placeholder text elements, the configuration data parameters may be updated to include instructions such as, *"the output must be formatted as:* "- *pre-heading* : *the pre-heading text content";* "- *sub-heading : the sub-heading text content".*

Further, as the length(s) and type(s) of text content may be different for different types of placeholder text elements, any number of words, characters, sentences or bullet points may be suitably specified in the configuration data. The types of few-shot examples provided may also be varied depending on the type of placeholder text element present in the design template.

Returning to method step 504, once the prompt generation module 115 receives the design template analysis data, it identifies the placeholder text element types required for each design template (e.g., by inspecting the corresponding analysis data) and then updates the parameters of the configuration data based on the identified placeholder text element types.

The prompt generation module 115 then generates the design content prompts for each design template in the design plan descriptor. To do so, for each design content prompt, it combines the user input prompt with the updated configuration data.

At step 606, once the design content prompts are generated, the prompt generation module 115 communicates the design content prompts to the ML module 114. The ML module 114 then communicates the page content prompts to the ML system 130. In some embodiments, where multiple design content prompts are created, the design content prompts may be communicated simultaneously to the ML system 130. In other embodiments, the design content prompts may be communicated sequentially - e.g., after receiving the ML system 130 output for a previous design content prompt.

By way of the text content configuration data, the LLM is cued to generate text content based, in part, on the user prompt and the parameters of the configuration data for each design template. For example, based on the example configuration data shown in table K, the ML system 130 may be cued to generate different types of text content (e.g., pre-heading, sub-heading, heading, body, etc.) of different structure and text length. The ML system 130 outputs the text content in accordance with the corresponding design content prompt.

At 608, the design content output by the ML system 130 for each design content prompt is received by the ML module 114 as a string of output text, referred to as a completion. The ML module 114 passes the output to the design generation module 116, which updates the design plan descriptor with the received text content.

At step 610, the design generation module 116 processes the completions, which may include analysing each completion to identify the respective text elements expected according to the template analysis data. For example, the design generation module 116 may parse or process the output text to identify a string of text following the appearance of one or more of "- pre-heading :"; "-heading :"; or "- sub-heading :" as defined by the output format of the text in the configuration data. Additionally or alternatively, text content may be identified according to line breaks, carriage returns and/or special characters as may be defined in the configuration data. Many alternative parsing, text analysis and processing techniques are also possible to identify the text elements in the completion.

At step 612, the design generation module 116 stores the identified text elements for each design template in the design plan descriptor. For example, the text elements may each be stored as a text element record having text content and a text hierarchy level. The text elements may map to a template ID of a corresponding design template from which the template analysis and placeholder text was used to generate the respective text elements. In some embodiments, the text elements may be stored as respective text content data (and metadata) of respective design templates in the design plan descriptor. The method 600 then ends.

In one example, for an input prompt of *"A social media post for the magic design software architecture page",* which is associate with four design templates (e.g. template1; template2; template3; template4), four design content prompts may be generated (as at 604) by combining the user prompt, and updated configuration data. The text content prompts are then passed to the ML system 130 (as at 606) which generates text content for each template.

The output text of the ML system for the 4 content prompts is displayed in the table L below -

**Table L: Example text content output**

| **Design content prompt** | **ML system output** |
|---|---|
| design content prompt1 | [{pre-heading1 : "*Magic of design*"}, {heading1 : *"Discover the best architecture design software*"}] |
| design content prompt2 | [{heading2 : *"Magic software architecture*"}] |
| design content prompts | [{heading3 : *"Magic Software Architecture Design your dream"},* {sub-heading3 : *"Intuitive and user-friendly bring your dreams to life"*}] |
| design content prompt4 | [{pre-heading4 : "*Magic Design*"}, {heading4 : "*The power of seamless design"*}] |

Whilst design plans are envisioned as being generated by providing separate respective design content prompts (e.g. input prompt and updated configuration data) to the ML system 130, in some embodiments, a single design content prompt may be generated for all the design templates.

It will be appreciated that in method 600, it is presumed that the configuration data is provided to the ML system 130 each time new page content is required. However, this need not be the case in all implementations. In other implementations, the page content configuration data for all the different page types may be provided to the ML system 130 each time an instance of the ML system 130 is invoked. If the same ML system instance is then used for subsequent page content requests, the configuration data need not be re-submitted to the ML system 130 as the ML system 130 can remember the configuration data it has been provided previously and utilize that configuration data for subsequent page content requests. Once the ML system instance is closed or exited, it may flush the configuration data and the server application 112 may need to resend the configuration data for all page types along with a page outline request when a new instance of the ML system 130 is invoked. Further, whilst page content has been described as being generated by providing separate respective page content prompts (e.g. user input prompt and respective page headline, and page configuration data) to the ML system 130, in some embodiments, a single page content prompt may be generated for all the pages or for all the pages of the same page type.

Further still, it is presumed that the ML system 130 is a general purpose LLM that has not previously been trained or configured to provide page content in the required manner. However, this need not be the case in all implementations. In some implementations, a specific purpose ML system may be adopted that has been trained using copious amounts of training data of page types, headlines and user prompts and desired output page content. There is no need to provide additional configuration data for such specifically trained ML systems 130 and in such cases, the page content prompt may simply include the user prompt and page headline.

Additionally, while methods 400 and 600 envision separate instances of the ML system 130 generating design outlines and the text content of each of the design templates, in some embodiments, a single instance of the ML system 130 could generate both the design outlines and the text content.

Referring now to FIG. 7, a method 700 for generating and outputting the final design is described. Method 700 will be described with reference to generating and outputting multiple candidate designs for a user to ultimately select from.

At 702, the design generation module 116 retrieves the design templates identified in the design plan descriptor 128. For example, where the design plan descriptor includes identifiers of the selected design templates, the design generation module 116 performs a search in the templates library using the template identifiers and retrieves the corresponding design template records.

At 704, for each design template record, text content from the design plan descriptor is transferred into the respective placeholder text element field. For example, for a first template (Template1) where text content of {pre-heading1 : "Magic of design"}, {heading1 : "Discover the best architecture design software"} was generated, the respective pre-heading and heading placeholder text elements fields can be updated with the text "Magic of design" and "discover the best architecture design software", respectively. Similarly, other placeholder text elements of the other design templates are updated with the corresponding text from the design plan descriptor.

At 706, for each design template record having a media placeholder element, a media item is selected from the design plan descriptor and the media placeholder element field in the design template record is updated with the selected media item identifier. In some embodiments, the media item is selected for a particular design template based on dimensions and/or aspect ratio of the placeholder element and the dimensions and/or aspect ratio of the available media items in the design plan descriptor. Where required, the media items may be cropped and/or scaled to fit the respective template placeholder element.

At 708, colour palettes are applied to the design template records. This may include the design generation module 116 retrieving the colour palette identifier from the design plan descriptor and adding it to the colour palette field of a corresponding design template record. Application of the colour palette effectively involve a recolouring of text and shape elements in the template from their default colouring. Such recolouring may, for example, be performed in accordance with a method such as method 500 described in Australian patent application 2021273643, filed on 26 November 2021 and titled "Systems and methods for automatically recolouring a design". In this case, the populated template and the colour palette associated with the respect populated template may be used as the input colour palette and input design of method 500 of Australian patent application 2021273643.

At 710, font palettes are applied to the design template records. This may include the design generation module 116 retrieving the font palette identifier from the design plan descriptor and adding it to the font palette field of a corresponding design template record. Application of the font palette may be performed based on fonts in the font palette being associated with respective text hierarchy levels. For example, a font palette may include heading type fonts, which are intended to be bold, elegant, and eye-catching; and body text type fonts, which are intended to be clean, legible, and easy-to-read. For each font palette and template, the respective fonts thereby to format the text displayed in each template. Font palettes may also format font size, centring or justification, and format the text as being bold, underlined, italics, or the like.

In steps 706, 708 and 710, the design generation module 116 may select respective media items, font palettes, and colour palettes for the design templates either randomly; according to the order the respective templates and media items, colour palettes, and font palettes were retrieved from respective libraries; and/or according to a predefined criteria, for example, most compatible, most relevant or the like. The relevance of a media item to a template may be determined, for example, according to matching terms (or synonyms) in media item metadata (e.g. image descriptors or tags) compared to terms in the heading text content of the respective template. The relevance of colour palettes and font palettes may also be determined according to matching terms (or synonyms) between respective style palette metadata and text content of templates. Additionally, the relevance of colour palettes, may be selected based on key colour data of a media item selected for the template. In some embodiments, additional or alternative colours or colour palettes may be extracted from the media item selected for the template. In another example, an ML model may be trained on a training set of designs having text content and media wherein the designs are ranked (e.g. by user ratings) and the ML model is then configured to select combinations of media items, font palettes and colour palettes for the candidate designs.

At step 712, the design generation module 116 generates candidate design records for each of the updated template records. The design generation module 116 may save these candidate design records using unique identifiers in the data store 119 (e.g., in a temporary cache). Further, the design generation module 116 communicates the candidate design records to the client application 142. At this stage, the design plan descriptor 128 may be discarded.

The client application 142 may then render the candidate designs for display on a UI on the client device 140 using the candidate design records. For example, for each candidate design, the client application 142 may retrieve the design template mentioned in the corresponding candidate design record from the database, add the text components mentioned in the placeholder element fields in the record into the corresponding placeholder elements, retrieve the media items mentioned in the corresponding design record from the media library and populate it in a corresponding placeholder element, and apply the font and colour palettes mentioned in the design record.

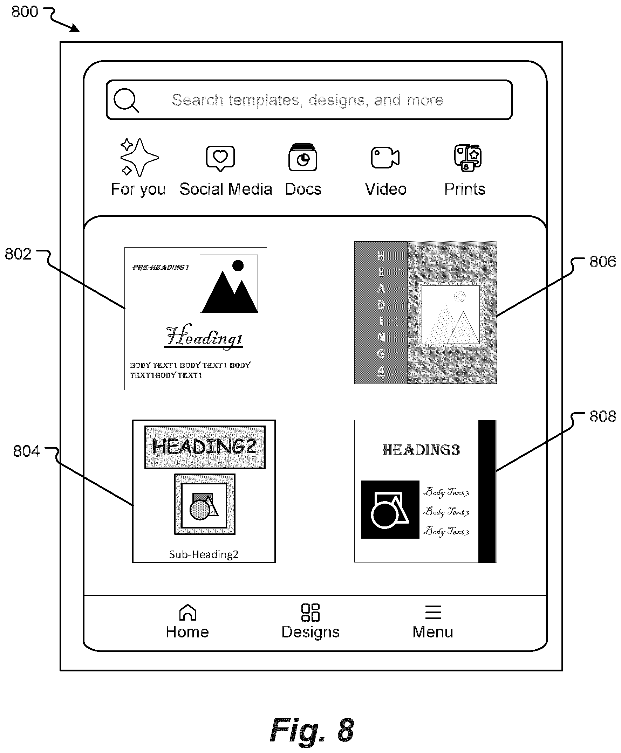

FIG. 8 shows an example UI 800 generated and displayed on the client system 140 at the end of method 300. In this example, the UI 800 displays 4 designs 802-808.

Once the candidate designs are displayed, the user may also be provided edit functionality within the UI 800 to alternate selected design assets between the candidate designs. For example, the user may be able to swap media items, colour palettes, and font palettes between and across the displayed candidate designs. Other editing functionality may include, for example: adding an element to the design; removing an element from the design (including removing elements that have been automatically generated for the design); editing an element that has been added to the design (including editing the elements that have been automatically generated for the design); and/or other operations.

UI 800 may also provide a user with various options for exporting the output design. This may include, for example, one or more options that allow a user to: determine an export location (e.g. on local memory such as 210 or a network accessible storage device); determine an export format (e.g. a file type); determine an export size/resolution; and/or other export options.

UI 800 may further provide a user with various options to share the design. This may include, for example, one or more options that allow a user to determine a format (e.g. file type) and then share the resulting design (e.g. by attaching it to an electronic communication, uploading to a web server, uploading to a social media service, or sharing in an alternative manner). Application 142 may also provide a user with the option of sending a link (e.g. a URL) to the design (e.g. by generating a link and attaching a link to an electronic communication or allowing a user to copy the link).

### Other embodiments

In some examples, different text content can be generated and populated in each design template, in alternative examples, the same text content may be used across the same text hierarchy level text elements of each design template. That is, all the candidate designs may have the same pre-heading, heading, sub-heading, and/or body text content.

In methods 300-700, the application 112 generates one or more candidate designs. It will be appreciated that the application 112 can be configured to generate any number of candidate designs using any number of style descriptors and media queries to retrieve any number of media items, colour palettes, font palettes, and templates. Furthermore, not all selected media items (or style attributes) need be utilised in the candidate designs. For example, six media items may been retrieved and only four may be selected for candidate design records. In some examples, the user may specify the number of candidate designs when providing the input prompt. In such cases, the user specified number overrides any default settings of the application 112.

Further still, although methods 300-700 describe that style attributes such as colour and font are selected during the design process, this need not be the case in all implementations. In some cases, the selected design templates may include their own default colour and font palettes. In such cases, colour and font may not be selected at step 504 and this step can be omitted.

Additionally or alternatively, design components may be used in more than one candidate design. For example the same media item may be displayed in two or more candidate designs. As another example, multiple candidate designs may utilize the same colour palette.

Furthermore, whilst the candidate designs are described herein as single page designs, the methods and systems described herein can be utilized to create multi-page designs.

The flowcharts illustrated in the figures and described above define operations in particular orders to explain various features. In some cases the operations described and illustrated may be able to be performed in a different order to that shown/described, one or more operations may be combined into a single operation, a single operation may be divided into multiple separate operations, and/or the function(s) achieved by one or more of the described/illustrated operations may be achieved by one or more alternative operations. Still further, the functionality/processing of a given flowchart operation could potentially be performed by (or in conjunction with) different applications running on the same or different computer processing systems.

The present disclosure provides various user interface examples. It will be appreciated that alternative user interfaces are possible. Such alternative user interfaces may provide the same or similar user interface features to those described and/or illustrated in different ways, provide additional user interface features to those described and/or illustrated, or omit certain user interface features that have been described and/or illustrated.

In the embodiments described above, the operations of methods 300, 400, 500, 600, and 700, are described as being performed by application 112 (and the various associated modules) running on a single computer processing system. The operations could, however, be performed by one or more alternative applications running on system 110 and/or one or more alternative computer processing systems. For example, one or more of modules 113-117 may be distinct applications (running on the same or separate computer processing systems) that interoperate with application 112 to perform the described techniques. In another example, the functions performed by modules 113-117 may be combined together in a design generation service that can be accessed by any appropriate application (e.g. a web browser or other application). In another example, the functionality of modules 113-117 may be provided by one or more client-side applications. In this case, application 142 may be configured to perform the relevant operations (e.g. those of modules 105-118) for generating a design.

As yet another example, the functions performed by modules 113-117 may be combined together in a design generation package that can be used to extend the functionality provided by any design production application. In this case the design generation package may be locally installed on a given end user system, e.g. as a plug-in or extension to an existing video production application.

In the above description, certain operations and features are explicitly described as being optional. This should not be interpreted as indicating that if an operation or feature is not explicitly described as being optional it should be considered essential. Even if an operation or feature is not explicitly described as being optional it may still be optional.

Unless otherwise stated, the terms "include" and "comprise" (and variations thereof such as "including", "includes", "comprising", "comprises", "comprised" and the like) are used inclusively and do not exclude further features, components, integers, steps, or elements.

In certain instances the present disclosure may use the terms "first," "second," etc. to describe various elements. Unless stated otherwise, these terms are used only to distinguish elements from one another and not in an ordinal sense. For example, a first element or feature could be termed a second element or feature or vice versa without departing from the scope of the described examples. Furthermore, when the terms "first", "second", etc. are used to differentiate elements or features rather than indicate order, a second element or feature could exist without a first element or feature. For example, a second element or feature could occur before a first element or feature (or without a first element or feature ever occurring).

It will be understood that the embodiments disclosed and defined in this specification extend to alternative combinations of two or more of the individual features mentioned in or evident from the text or drawings. All of these different combinations constitute alternative embodiments of the present disclosure.

The present specification describes various embodiments with reference to numerous specific details that may vary from implementation to implementation. No limitation, element, property, feature, advantage or attribute that is not expressly recited in a claim should be considered as a required or essential feature. Accordingly, the specification and drawings are to be regarded in an illustrative rather than a restrictive sense.

Background information described in this specification is background information known to the inventors. Reference to this information as background information is not an acknowledgment or suggestion that this background information is prior art or is common general knowledge to a person of ordinary skill in the art.

## Claims

1. A computer implemented method for automatically generating a design, the method including:
receiving an input prompt for generating the design;
generating a design outline based on the input prompt, the design outline including a style descriptor for the design;
retrieving a design template based on the design outline, the design template including a placeholder design element;
retrieving at least one design element for the placeholder element; and
generating the design by populating the placeholder element with the design element.

2. The computer implemented method of claim 1, wherein generating the design outline includes:
generating a design outline prompt, the design outline prompt including the input prompt; and
communicating the design outline prompt to a first machine learning system configured to generate the design outline based on the design outline prompt.

3. The method of claim 2, wherein the design outline prompt further includes configuration data to configure the first machine learning system to generate the design outline.

4. The computer implemented method of any one of the preceding claims, wherein retrieving the design element includes:
generating a design element prompt, the design element prompt including the input prompt;
communicating the design element prompt to a second machine learning system configured to generate the design element based on the input prompt.

5. The computer implemented method of claim 4, wherein the design element prompt further includes configuration data to configure the second machine learning system to generate the design element, wherein the configuration data is based on a type of the placeholder element.

6. The computer implemented method of claim 5, wherein generating the design element includes:
processing data associated with the design template to identify the placeholder element.

7. The computer implemented method of claim 6, wherein the placeholder element includes a text hierarchy level and the design element is retrieved based on the text hierarchy level.

8. The computer implemented method of any one of the preceding claims, wherein the design outline includes a media query.

9. The computer implemented method of any one of the preceding claims, wherein retrieving the design template includes searching a template library using the style descriptor and retrieving the design template from search results.

10. The computer implemented method of any one of the preceding claims, further including searching a style attributes library for a style attribute palette using the style descriptor and selecting the style attribute palette.

11. The computer implemented method of claim 10, wherein generating the design includes applying the style attribute to the design template.

12. The computer implemented method of any one of claims 8 to 11, further including searching a media item library for a media item using the media query and selecting the media item.

13. The computer implemented method of claim 12, wherein the design template includes a placeholder shape element and the method further includes populating the placeholder shape element with the media item.

14. A computer processing system including:
one or more computer processing units; and
non-transitory computer-readable medium storing instructions which, when executed by the one or more computer processing units, cause the one or more computer processing units to perform a method according to any one of claims 1 to 13.

15. Non-transitory storage storing instructions executable by one or more computer processing units to cause the one or more computer processing units to perform a method according to any one of claims 1 to 13.
